# EUROPEAN PATENT SPECIFICATION

(11) **EP 0 507 545 B1**
(45) Date of publication and mention of the grant of the patent: **19.03.1997**
(21) Application number: 92302824.5
(22) Date of filing: 31.03.1992
(51) Int. Cl.: C23C 14/08

(54) **Titanium oxide films and their production**
Titan-Oxid-Schichten und deren Herstellung
Films d'oxyde de titane et leur préparation

(30) Priority: 03.04.1991 JP 98283/91
(43) Date of publication of application: 07.10.1992
(73) Proprietor: NISSHIN STEEL CO., LTD., Chiyoda-ku Tokyo 100 (JP)
(72) Inventor: Mizuno, Atsushi, c/o Tekko Kenkyusho, Sakai-shi, Osaka (JP); Fukui, Yasushi, c/o Tekko Kenkyusho, Sakai-shi, Osaka (JP); Nakamoto, Kazunari, c/o Tekko Kenkyusho, Sakai-shi, Osaka (JP); Yoshii, Tsuguyasu, c/o Tekko Kenkyusho, Sakai-shi, Osaka (JP)
(74) Representative: BATCHELLOR, KIRK & CO.

(56) References cited:
- GB-A- 2 028 376
- PATENT ABSTRACTS OF JAPAN vol. 12, no. 433 (C-543)(3280) 15 November 1988
- PATENT ABSTRACTS OF JAPAN vol. 12, no. 373 (C-534)(3220) 6 October 1988
- PATENT ABSTRACTS OF JAPAN vol. 11, no. 322 (C-453)(2769) 20 October 1987
- APPLIED PHYSICS LETTERS vol. 54, no. 3, 16 January 1989, NEW YORK pages 231 - 232; H. NOZOYE ET AL.: 'REACTIVE EVAPORATION OF TITANIUM OXIDE FILMS WITH CONTROLLED TI/O RATIO'

## Description

The present invention relates to titanium oxide films having a blue colour, which can be formed on a surface of a metallic material to serve as a metallic ornament such as a watch band, frames of eyeglasses and accessories, and to ornaments for indoor use, to provide a blue exterior.

In order to impart a blue metallic lustre on a surface of the metallic material, a transparent oxide thin film which causes a blue interference colour is formed on the surface thereof. The transparent oxide thin film can be formed by ion plating, sputtering, chemical colouring process, sol-gel process, and other techniques.

The blue produced by the interference colour varies with the thickness of the film. In order to obtain a constant tone, the film must have a constant thickness. However, it is difficult to form such a thin film by conventional methods while precisely controlling its thickness. In addition, the film tends to assume other colours unless the film is precisely and evenly distributed. As a result, the tone of the film varies slightly for every production lot.

Moreover, the colour varies according to the angle at which the coated surface is seen. Namely, the surface may assume blue when viewed only from one direction, the front, for example, and assume another colour when viewed from another direction.

Japanese Patent Application Laid-Open 63-161156 discloses another method of imparting blue to a metal surface. In accordance with the method, a mixed thin film which contains a mixture of titanium oxides such as titanium monoxide (TiO) and titanium trioxide (Ti₂O₃) is precipitated by ion plating to form a blue thin film. Although the thickness of the film may not be precisely controlled, the surface assumes a uniform colour. However, the obtained colour is dark and lacks vividness.

The reader is also referred to JP-A-63-125 660 which discloses formation of titanium oxide films on a steel plate, wherein the plate is placed in a vacuum chamber which is evacuated, the titanium is vaporised and the film formed by ion plating in an oxygen-containing atmosphere.

The inventors filed Japanese Patent Application 2-270108 (Publication No. JP-A-4 147 963) relating to a mixed film whose average oxygen content is from 52 to 59 atom percent and the film comprises a mixture of titanium monoxide (TiO), titanium dioxide (TiO₂) and other titanium oxides which are expressed as TiₙO₂ₙ₋₁ where n is an integer larger than 2. Neither the thickness of the film nor the viewing angle at which the film is viewed affects the colour of the blue film.

The inventors of the present invention have now surprisingly found that the type of the titanium oxides and the oxygen content in the film are important factors in determining the colour of the film.

An object of the present invention is to provide an improved titanium oxide mixture film which assumes brighter blue.

According to the present invention, there is provided in one aspect a metallic material coated with a titanium oxide blue film consisting essentially of titanium monoxide (TiO), titanium dioxide (TiO₂), titanium trioxide (Ti₂O₃), titanium pentoxide (Ti₃O₅) and other titanium oxides which are expressed as TiₙO₂ₙ₋₁ where n is an integer from 4 to 10, and the average content of oxygen in the film being from 51 to 59 atom percent.

According to another aspect of the present invention there is provided a method of forming a titanium oxide blue film on a metallic material such as a plate comprising:
disposing the metallic material in a vacuum chamber;
vaporizing titanium in the vacuum chamber;
ionizing the titanium vapor; and
introducing oxygen in the vacuum chamber to produce titanium oxides consisting essentially of titanium monoxide (TiO), titanium dioxide (TiO₂), titanium trioxide (Ti₂O₃₎, titanium pentoxide (Ti₃O₅) and other titanium oxides which are expressed as TiₙO₂ₙ₋₁ where n is an integer from 4 to 10, and the average content of oxygen in the film being from 51 to 59 atom percent.

The metallic material can be of stainless steel and may be a plate, watch case, watch band, spectacle frame or an ornament.

The blue of the film is caused not by an interference colour, but by the titanium oxides. Thus, the film assumes the same colour although the thickness of the film may be uneven, or the viewing angle at which the surface of the film is viewed may change. The colour of the mixed titanium oxide film of the present invention is luminous and brighter than that of a conventional titanium oxide film. When the oxygen content is less than 51 atom percent, the tone of the blue darkens. If the oxygen content is more than 59 atom percent, the blue has low colour saturation to be whitened. The blue thin film is preferably formed by vacuum deposition of titanium while controlling the pressure and other condition, of the ambient atmosphere.

In order that the invention may be illustrated and readily carried into effect, embodiments thereof will now be described by way of non-limiting examples only, with reference to the accompanying drawings, wherein:
Fig. 1 shows schematic diagram of one form of apparatus for ionizing and vacuum-depositing titanium to form a blue mixed titanium oxide thin film,
Fig. 2 is a graph showing an X-ray diffraction pattern of the blue mixed titanium oxide film;
Fig. 3 is a graph showing tones of the blue titanium oxide films of the present invention and of the prior art, respectively; and
Fig. 4 is a graph showing lightness of the blue titanium oxide films of the present invention and of the prior art, respectively.

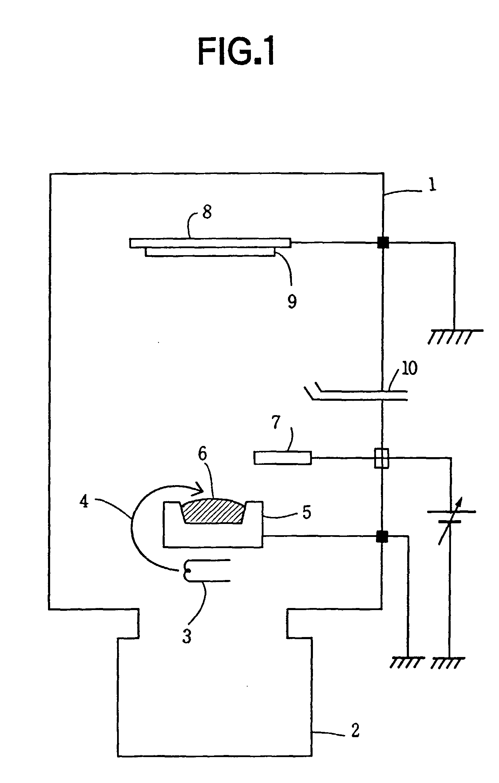

Referring to Fig. 1, a device suitable for forming a mixed titanium oxide film on a metal plate 9 comprises a vacuum chamber 1 provided with a vacuum pump 2 mounted at a bottom portion of the vacuum chamber 1 for discharging air in the chamber. A holder 8 having a heater is mounted in an upper portion of the chamber 1 for supporting the plate 9. A crucible 5, wherein a lump of titanium 6 as an ion source is disposed, is positioned in a lower portion of the chamber 1. Provided under the crucible 5 is an electron gun 3, and above the crucible 5 is an ionization electrode 7. A gas induction nozzle 10 is attached on a wall of the chamber 10 to supply oxygen.

The operation of the device is described. The metal plate 9, for example, a SUS 304 (Trademark) stainless steel plate, which measures 100 mm by 100 mm by 0.5 mm thickness, is mounted on the holder 8. The vacuum pump 2 is driven to reduce the pressure in the chamber 1 to 2,66 x 10⁻³ Pa (2.0 x 10⁻⁵ Torr), and the plate 9 is heated by the heater of the holder 8 to 400°C. An electron beam 4 produced by the electron gun 3 melts and vaporizes the titanium 6 in the crucible 5. When the electrode 7 is energized with 50 V, an arc discharge is developed between the titanium 6 and the electrode 7, thereby ionizing the titanium vapour.

Oxygen is introduced into the chamber 1 through the nozzle 10 while maintaining the pressure therein at 2,66 x 10⁻³ Pa (2.0 x 10⁻⁵ Torr). The oxygen reacts with the ionized titanium vapor so that various titanium oxides are formed in the chamber. The oxides are deposited on the surface of the plate 9, thereby forming a mixed titanium oxide film of 2 µm.

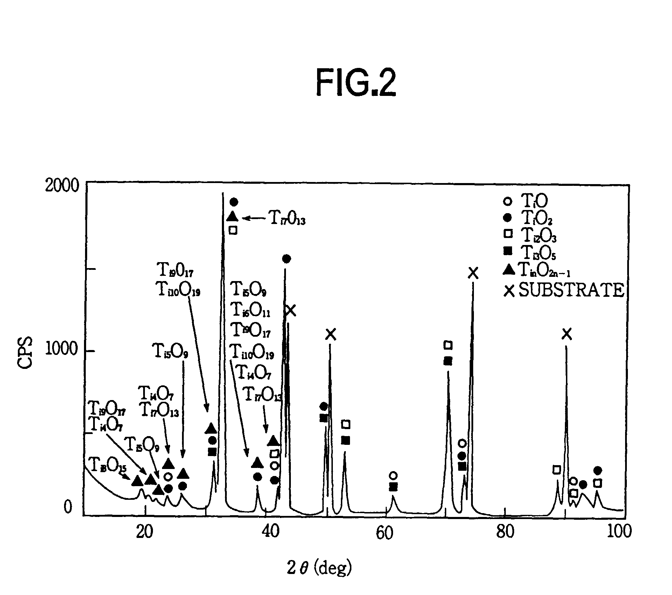

The content of oxygen in the film which was measured by Auger electron spectroscopy was 55 atom percent. As shown by the X-ray diffraction pattern in Fig. 2, the titanium oxide film formed on the plate 9 comprised titanium monoxide (TiO), titanium dioxide (TiO₂), titanium trioxide (Ti₂O₃), titanium pentoxide (Ti₃O₅) and other titanium oxides expressed as TiₙO₂ₙ₋₁ where n is an integer between 4 and 10.

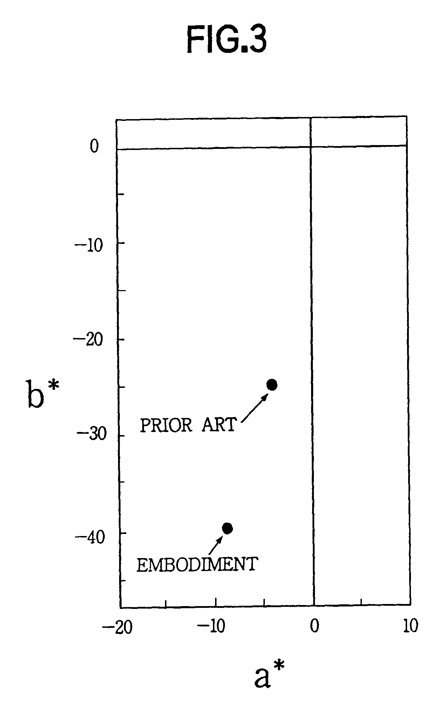

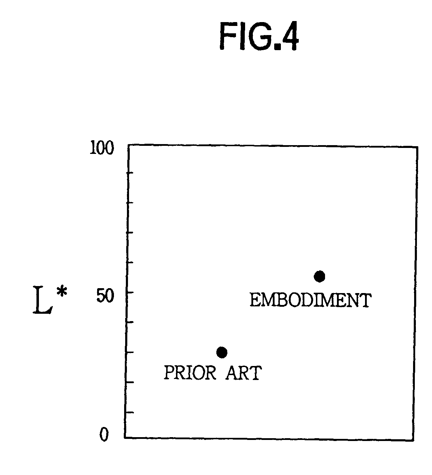

Figs. 3 and 4 respectively show the tone and the lightness of the titanium oxide film thus formed, indicated by the CIELAB system of colour representation where the standard source C is used. Referring to Fig. 3, an increase in positive direction along the a∗-axis represents increase of red and increase in negative direction represent increase of green. An increase in positive direction along the b∗-axis represents an increase of yellow and an increase in negative direction represents an increase of blue. The origin indicates an achromatic colour As shown in the graph, whereas the colour of a conventional titanium oxide film falls on a point about -25 on the b∗-axis, the color of the film of the present invention is about -40. Namely, the blue of the present film is more chromatic, so that a more vivid blue film is obtained.

Referring to Fig. 4, the ordinate L∗ indicates lightness. The lightness of the blue of the film according to the present invention is substantially increased to about 55 from that of the conventional film, which is about 30.

From the foregoing, it will be understood that the present invention provides, in one aspect, metallic material coated with a thin film comprising a mixture of various titanium oxides as a blue coating. The colour of the film is vivid and bright so that an ornament or other article having an attractive and refined appearance can be provided.

The present invention also provides and includes within its scope a method of coating a substrate, such as a method of forming a titanium oxide blue film on a substrate with a metal surface. It also includes a substrate having a surface coated with such a film e.g. a metal watch band, spectacle frames and ornaments.

## Claims

1. A metallic material coated with a titanium oxide blue film consisting essentially of titanium monoxide (TiO), titanium dioxide (TiO₂), titanium trioxide (Ti₂O₃), titanium pentoxide (Ti₃O₅) and other titanium oxides which are expressed as TiₙO₂ₙ₋₁ where n is an integer from 4 to 10, and the average content of oxygen in the film being from 51 to 59 atom percent.

2. The metallic material as claimed in claim 1 which is made of stainless steel.

3. The metallic material as claimed in claim 1 or 2 which is a plate, watch case, watch band, spectacle frame or an ornament.

4. A method of forming a titanium oxide blue film on a metallic material such as a plate comprising:
disposing the metallic material in a vacuum chamber;
vaporizing titanium in the vacuum chamber;
ionizing the titanium vapor; and
introducing oxygen in the vacuum chamber to produce titanium oxides consisting essentially of titanium monoxide (TiO), titanium dioxide (TiO₂), titanium trioxide (Ti₂O₃₎, titanium pentoxide (Ti₃O₅) and other titanium oxides which are expressed as TiₙO₂ₙ₋₁ where n is an integer from 4 to 10, and the average content of oxygen in the film being from 51 to 59 atom percent.

## Patentansprüche

1. Metallisches Material, das mit einem blauen Titanoxidfilm beschichtet ist, der im wesentlichen aus Titanmonoxid (TiO), Titandioxid (TiO₂), Titantrioxid (Ti₂O₃), Titanpentoxid (Ti₃O₅) und anderen Titanoxiden besteht, die als TiₙO₂ₙ₋₁ ausgedrückt werden, wobei n eine ganze Zahl von 4 bis 10 ist und der mittlere Sauerstoffgehalt in dem Film 51 bis 59 Atom-% beträgt.

2. Metallisches Material nach Anspruch 1, das aus Edelstahl hergestellt ist.

3. Metallisches Material nach Anspruch 1 oder 2, das eine Platte, ein Uhrengehäuse, ein Uhrenarmband, ein Brillengestell oder ein Ornament ist.

4. Verfahren zur Bildung eines blauen Titanoxidfilms auf einem metallischen Material, wie etwa einer Platte, bei dem man
das metallische Material in einer Vakuumkammer anordnet,
in der Vakuumkammer Titan verdampft,
den Titandampf ionisiert, und
in die Vakuumkammer Sauerstoff einführt, um Titanoxide zu erzeugen, die im wesentlichen aus Titanmonoxid (TiO), Titandioxid (TiO₂), Titantrioxid (Ti₂O₃), Titanpentoxid (Ti₃O₅) sowie anderen, als TiₙO₂ₙ₋₁ ausgedrückten Titanoxiden bestehen, wobei n eine ganze Zahl von 4 bis 10 ist und der mittlere Sauerstoffgehalt in dem Film 51 bis 59 Atom-% beträgt.

## Revendications

1. Matériau métallique revêtu d'un film bleu d'oxyde de titane se composant essentiellement de monoxyde de titane (TiO), de dioxyde de titane (TiO₂), de trioxyde de titane (Ti₂O₃), de pentoxyde de titane (Ti₃O₅) et d'autres oxydes de titane que l'on exprime sous la forme TiₙO₂ₙ₋₁, où n est un entier compris entre 4 et 10, et la teneur moyenne en oxygène dans le film est comprise entre 51 et 59 pourcent atomiques.

2. Matériau métallique selon la revendication 1, qui est fait en acier inoxydable.

3. Matériau métallique selon la revendication 1 ou 2, qui est une plaque, un boîtier de montre, un bracelet de montre, une monture de lunettes ou un objet décoratif.

4. Procédé de formation d'un film bleu d'oxyde de titane sur un matériau métallique tel qu'une plaque, comprenant les étapes consistant à :
placer le matériau métallique dans une chambre à dépression ;
vaporiser le titane dans la chambre à dépression ;
ioniser la vapeur de titane ; et
introduire de l'oxygène dans la chambre à dépression pour produire des oxydes de titane se composant essentiellement de monoxyde de titane (TiO), de dioxyde de titane (TiO₂), de trioxyde de titane (Ti₂O₃), de pentoxyde de titane (Ti₃O₅) et d'autres oxydes de titane que l'on exprime sous la forme TiₙO₂ₙ₋₁, où n est un entier compris entre 4 et 10, et la teneur moyenne en oxygène dans le film est comprise entre 51 et 59 pourcent atomiques.
